(19) **Europäisches Patentamt / European Patent Office / Office européen des brevets**

(11) **EP 4 092 435 B1**

(12) **FASCICULE DE BREVET EUROPEEN**

(45) Date de publication et mention de la délivrance du brevet:
**23.08.2023 Bulletin 2023/34**

(21) Numéro de dépôt: **22173829.7**

(22) Date de dépôt: **17.05.2022**

(51) Classification Internationale des Brevets (IPC):
**G01R 31/52** *(2020.01)* **B60M 5/00** *(2006.01)*

(52) Classification Coopérative des Brevets (CPC):
**G01R 31/52; B60M 5/00;** G01R 31/085

(54) **MÉTHODE DE SURVEILLANCE DE L'ÉVOLUTION DES COURANTS VAGABONDS D'UNE INFRASTRUCTURE FERROVIAIRE ET INFRASTRUCTURE FERROVIAIRE SURVEILLÉE PAR UNE TELLE MÉTHODE**

VERFAHREN ZUR ÜBERWACHUNG DER ENTWICKLUNG VON STREUSTRÖMEN EINER EISENBAHN-INFRASTRUKTUR UND EISENBAHN-INFRASTRUKTUR, DIE MIT EINEM SOLCHEN VERFAHREN ÜBERWACHT WIRD

METHOD FOR MONITORING THE EVOLUTION OF STRAY CURRENTS OF A RAILWAY INFRASTRUCTURE AND RAILWAY INFRASTRUCTURE MONITORED BY SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.05.2021 FR 2105190**

(43) Date de publication de la demande:
**23.11.2022 Bulletin 2022/47**

(73) Titulaire: **ALSTOM Holdings**
**93400 Saint-Ouen-sur-Seine (FR)**

(72) Inventeurs:
• **DESMARAIS, Cédric**
**93400 Saint Ouen-sur-Seine (FR)**
• **FAZAA, Alexandre**
**93400 Saint Ouen-sur-Seine (FR)**

(74) Mandataire: **Lavoix**
**2, place d'Estienne d'Orves**
**75441 Paris Cedex 09 (FR)**

(56) Documents cités:
WO-A1-2017/082730    DE-C1- 10 111 156
US-A1- 2004 104 723    US-A1- 2017 168 106

**Description**

La présente invention concerne une méthode de surveillance de l'évolution des courants vagabonds d'une infrastructure ferroviaire et une infrastructure ferroviaire surveillée par une telle méthode.

Il est connu de US2004104723A1 de proposer une méthode pour identifier les risques induits par des défauts d'isolation sur une infrastructure ferroviaire par les courants vagabonds générés par le passage de trains, cette méthode consistant à analyser le voltage généré par les courants vagabonds en de nombreux points de mesure répartis sur l'infrastructure et en comparant ces mesures à des valeurs de référence. De par la variabilité des courants vagabonds générés par les trains, cette méthode présente l'inconvénient de nécessiter un très grand nombre de mesures, et donc de devoir recourir à une analyse complexe et onéreuse.

Un autre document pertinent est WO 2017/082730 A1.

C'est à ces inconvénients qu'entend plus particulièrement remédier l'invention en proposant une méthode de surveillance de l'évolution des courants vagabonds d'une infrastructure ferroviaire plus simple à mettre en oeuvre et moins onéreuse.

À cet effet, l'invention concerne une méthode de surveillance de l'évolution des courants vagabonds d'une infrastructure ferroviaire, l'infrastructure ferroviaire comprenant :

- des rails posés sur un sol et isolés du sol par un système d'isolation, les rails définissant au moins une section (S, S') de voie ;
- des sous-stations générant une tension, de préférence continue, d'alimentation d'un véhicule ferroviaire ; et
- un système de surveillance comprenant au moins un capteur de tension rail-sol et au moins une unité de calcul.

Selon l'invention, l'infrastructure ferroviaire comprend en outre au moins une source de courant stabilisée, la méthode de surveillance comprend une phase d'exploitation comprenant au moins les étapes suivantes :

- émission d'un courant stabilisé par chaque source de courant dans au moins un des rails ;
- mesure de la tension générée par le courant stabilisé entre les rails et le sol par l'au moins un capteur de tension rail-sol ;
- calcul, par l'unité de calcul, du courant circulant dans chaque section issu de la source de courant ; et
- analyse par l'unité de calcul de la tension mesurée par le capteur de tension rail-sol et du courant calculé et détection d'une possible dégradation de l'isolation entre les rails et le sol,

et en ce que, au cours de la phase d'analyse, l'unité de calcul analyse la tension mesurée par le capteur de tension rail-sol et le courant calculé et détecte une possible dégradation de l'isolation entre les rails et le sol par comparaison d'une part de la tension mesurée à une valeur précédente de tension rail-sol et d'autre part du courant calculé à une valeur précédente du courant circulant dans les rails.

Grâce à l'invention, il est possible de proposer une méthode de surveillance de l'évolution des courants vagabonds d'une infrastructure ferroviaire basée sur une analyse des tensions générées par un courant stabilisé maîtrisé, ce qui diminue les coûts de cette analyse et simplifie la mise en oeuvre de la surveillance.

Selon des aspects avantageux, mais non obligatoire de l'invention, cette méthode de surveillance peut incorporer une ou plusieurs des caractéristiques suivantes, prises selon toutes combinaisons techniquement admissibles :

- La méthode comporte une phase de déploiement comprenant au moins une étape initiale consistant, d'une part, à mesurer pour chaque capteur de tension rail-sol une valeur de référence de la tension générée par le courant stabilisé entre les rails et le sol et, d'autre part, à calculer pour chaque section une valeur de référence du courant circulant dans les rails issu de la source de courant.
- Au cours de l'étape d'analyse par l'unité de calcul, pour chaque capteur de tension rail-sol, la comparaison est effectuée entre la tension rail-sol mesurée lors de l'étape de mesure et la valeur de référence de la tension rail-sol mesurée lors de l'étape de mesure initiale, et pour chaque section, la comparaison est effectuée entre le courant circulant sur la section calculé lors de l'étape de calcul et la valeur de référence du courant circulant dans les rails calculée lors de l'étape de calcul initial.
- Le système de surveillance de l'infrastructure ferroviaire comprend au moins deux capteurs de tension rail-sol et au moins deux sections et l'étape d'analyse de la phase d'exploitation localise l'emplacement sur les rails de la dégradation de l'isolation entre les rails et le sol en identifiant la section sur laquelle la variation du courant est la plus forte, la dégradation de l'isolation étant réputée être située sur cette section.
- Le système de surveillance de l'infrastructure ferroviaire comprend au moins deux capteurs de tension rail-sol et au moins deux sections et l'étape d'analyse de la phase d'exploitation localise l'emplacement sur les rails de la dégradation de l'isolation entre les rails et le sol sur la base d'un modèle comprenant des résistances longitudinales représentant chacune la résistance électrique longitudinale du rail sur une sections et des résistances transversales représentant l'isolement rail-sol au niveau des capteurs de tension rail-sol, dans lequel les résistances transversales sont calculées à partir de la tension entre les rails et le sol mesurée par les capteurs de tension, du courant émis par les sources de courant et des résistances longitudinales, de préférence à l'aide d'un calcul matriciel, et dans lequel les valeurs des résistances transversales sont comparées avec des valeurs de référence, calculées au cours d'une phase de déploiement de la méthode de surveillance, pour localiser l'emplacement de la dégradation de l'isolation.

- La phase d'exploitation est exécutée en l'absence de circulation de véhicules ferroviaires sur l'infrastructure ferroviaire et la phase d'exploitation comporte une étape supplémentaire, préalable à l'étape d'émission d'un courant stabilisé, qui consiste à vérifier l'absence de circulation de véhicules ferroviaires sur l'infrastructure.

- La phase d'exploitation comporte une étape supplémentaire consistant à calculer, pour chaque section, une valeur de l'isolation entre les rails et le sol en approximant le courant circulant dans les rails et en ce que l'étape d'analyse de la phase d'exploitation analyse également cette valeur d'isolation pour détecter une possible dégradation de l'isolation entre les rails et le sol.

- L'infrastructure ferroviaire comporte en outre des capteurs annexes de tension des rails disposés à chaque extrémité de chaque section, au cours de l'étape de mesure de la phase d'exploitation, les capteurs annexes mesurent la tension des rails à chaque extrémité de chaque section lorsqu'un courant stabilisé est émis par la source de courant, la phase d'exploitation comporte une étape de calcul supplémentaire dans laquelle l'unité de calcul calcule, à partir de ces tensions des rails, le courant circulant sur les rails à chaque extrémité de chaque section des rails, au cours de l'étape de calcul de la phase d'exploitation, à partir de ces courants, l'unité de calcul calcule une valeur de l'isolation entre les rails et le sol pour chaque section, et au cours de l'étape d'analyse de la phase d'exploitation, l'unité de calcul analyse, pour chaque section des rails, l'évolution de l'isolation entre les rails et le sol pour détecter une possible dégradation de cette isolation.

Selon un autre aspect, l'invention concerne aussi une infrastructure ferroviaire comprenant :

- des rails posés sur un sol et isolés du sol par un système d'isolation ;
- des sous-station générant une tension, de préférence continue, d'alimentation d'un véhicule ferroviaire ; et
- un système de surveillance comprenant des capteurs de tension rail-sol et au moins une unité de calcul.

Selon l'invention, cette infrastructure comprend en outre :

- au moins une source de courant stabilisée ;
- éventuellement des capteurs annexe de tension des rails ; et
- des moyens de mise en oeuvre de la méthode de surveillance mentionnée ci-dessus.

Cette infrastructure induit les mêmes avantages que ceux mentionnés ci-dessus au sujet de la méthode de surveillance de l'invention.

L'invention sera mieux comprise et d'autres avantages de celle-ci apparaitront plus clairement à la lumière de la description qui va suivre d'un mode de réalisation d'une méthode de surveillance de l'évolution des courants vagabonds d'une infrastructure ferroviaire et d'une infrastructure ferroviaire surveillée grâce à cette méthode, donnée uniquement à titre d'exemple et faite en référence aux dessins annexés dans lesquels :

[Fig. 1] la figure 1 est un schéma d'une infrastructure ferroviaire conforme à l'invention ; et
[Fig. 2] la figure 2 est un logigramme de la méthode de surveillance des courants vagabonds selon l'invention.

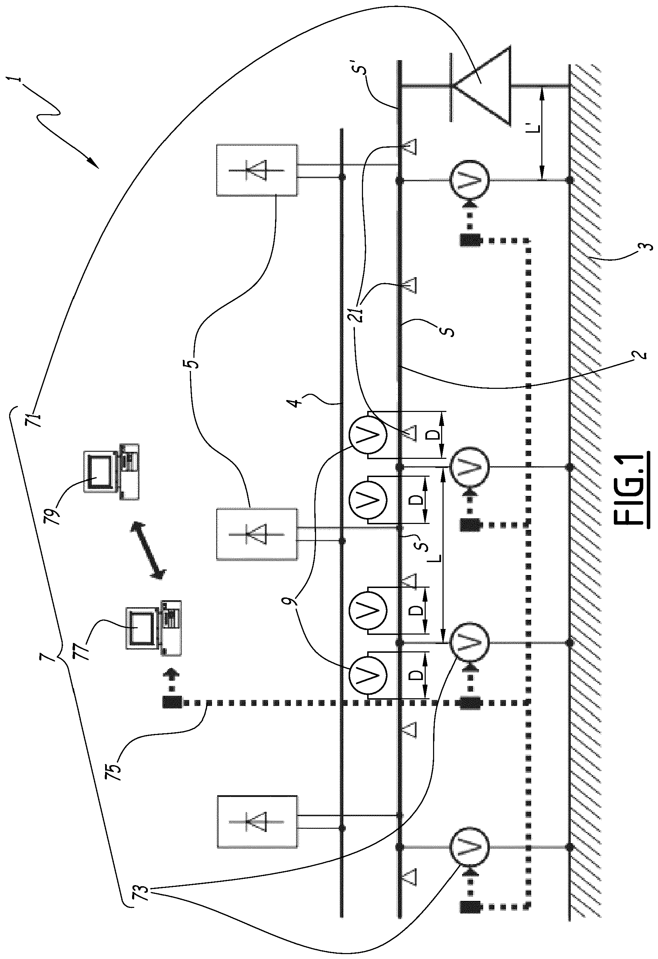

Une infrastructure ferroviaire 1 est représentée schématiquement à la figure 1. Cette infrastructure comprend des rails 2 formant une voie de circulation posée sur un sol 3, une ligne de contact 4 et plusieurs sous-stations 5. La ligne de contact 4 est, par exemple, une caténaire, une ligne aérienne de contact ou une alimentation par le sol prenant la forme d'un rail dédié à l'alimentation électrique.

Un véhicule ferroviaire non-représenté, par exemple un train, un tramway ou un métro, peut circuler sur les rails 2. Ce véhicule est alimenté en énergie électrique par les sous-stations 5, qui génèrent une tension, de préférence une tension continue, entre les rails 2 et la ligne de contact 4. En pratique ces sous-stations sont réparties le long des rails 2, par exemple tous les 2 à 5 km dans le cas d'un tramway circulant en milieu urbain et délivrent une tension continue entre 600 et 3000 V, par exemple de 1500 V, entre les rails 2 et la ligne de contact 4.

Le courant d'alimentation nécessaire à la mise en mouvement du véhicule est délivré au véhicule par l'intermédiaire de la ligne de contact 4. Le captage du courant du véhicule sur la ligne de contact s'effectue par exemple par un pantographe ou par une perche. Le courant de retour circule depuis le véhicule vers les sous-stations 5 par l'intermédiaire des rails 2, qui sont fabriqués en matériau conducteur d'électricité.

Les rails 2 sont posés sur un système d'isolation 21, lui-même posé sur le sol 3. Ainsi, les rails 2 sont donc normalement isolés électriquement du sol 3.

Le système d'isolation 21 ne permet néanmoins qu'une isolation électrique imparfaite. Ainsi, le courant de retour circulant par les rails entre le véhicule et les sous-stations crée une tension entre les rails 2 et le sol 3 et cette tension crée des courants vagabonds. Ces courants vagabonds sont des courants qui quittent les rails 2 et qui circulent entre le véhicule et les sous-station par d'autres chemins non-maîtrisés, généralement des infrastructures métalliques enterrées, par exemple des conduites de gaz. Ces courants vagabonds peuvent avoir pour conséquence la corrosion d'éléments métalliques situés à proximité des rails 2, et donc leur détérioration.

La localisation et l'intensité des courants vagabonds varie au cours du temps lors de l'exploitation de l'infrastructure ferroviaire 1. Cette variation est par exemple causée par une dégradation des matériaux des rails 2 et du système d'isolation 21.

Pour l'exploitant de l'infrastructure ferroviaire 1, il est important de connaître l'évolution de ces courants vagabonds, et donc de connaître l'évolution de l'isolation entre les rails 2 et le sol 3.

Conformément à l'invention, cette évolution est mesurée à l'aide d'un système de surveillance 7.

Le système de surveillance 7 comprend une source de courant stabilisée 71, des capteurs de tension rails-sol 73, un réseau de communication 75, une unité locale de calcul 77 et une unité de calcul déportée 79.

La source de courant stabilisée 71 désigne en pratique une source ajustable de courant continu, reliée à un réseau électrique non-représenté, et alimentée par ce réseau électrique. Cette source de courant est qualifiée de « stabilisée » car le courant fourni ne dépend pas, ou dépend de manière non-significative :

- des variations de la valeur efficace et de la fréquence de l'alimentation fournie par le réseau électrique pouvant se produire pendant une journée ;
- des microcoupures pouvant se produire dans l'alimentation fournie par le réseau électrique ; et
- des caractéristiques électriques de l'infrastructure ferroviaire 1.

Lorsqu'aucun véhicule ferroviaire ne circule sur les rails 2, la source de courant stabilisée émet un courant de contrôle qui se propage dans les rails. La présence de ce courant de contrôle génère une tension entre les rails 2 et le sol 3, dénommée tension rail-sol. Les capteurs de tension 73 permettent de mesurer cette tension rail-sol. Les capteurs de tension sont disposés tout au long des rails 2, par exemple en étant espacés d'une distance L comprise entre 0,5 et 5 km, de préférence égale à 1 km. En pratique, les capteurs de tension sont de préférence placés au niveau des sous-stations 5. Les rails 2 sont alors composés de sections de voie S de longueur L, une section de voie s'étendant entre deux capteurs de tension 73 successifs. De préférence, la longueur L est la même pour toutes les sections S. Les rails comprennent en outre une section initiale S', qui s'étend entre la source de courant stabilisée 71 et le capteur de tension 73 le plus proche de cette source. La longueur L' de cette section S' est de préférence la plus courte possible.

Les mesures effectuées par les capteurs de tension 73 sont ensuite transmises par le réseau de communication 75 jusqu'à l'unité locale de calcul 77 qui est, par exemple, un ordinateur, puis de l'unité locale jusqu'à l'unité de calcul déportée 79 qui est, par exemple, un serveur, par des moyens de communication à distance, par exemple par Internet.

La tension rail-sol mesurée par les capteurs 73 dépend principalement de trois facteurs :

- le courant de contrôle circulant dans les rails 2 ;
- la résistance électrique linéique des rails ; et
- l'isolation entre les rails et le sol.

La résistance électrique linéique des rails est définie comme étant la résistance des rails au passage d'un courant électrique par unité de longueur, exprimée en Ohm par kilomètre.

Deux capteurs de tension, non-représentés, sont placés de part et d'autre de la source de courant stabilisée. Ces capteurs permettent de mesurer, par une méthode connue, la résistance électrique linéique des rails, notée $R_{rail}$ et exprimée en Ohm/km, lorsque la source de courant 71 émet le courant de contrôle.

Le courant de contrôle généré par la source de courant 71 étant maîtrisé et constant dans le temps durant le fonctionnement du système de surveillance et la résistance électrique linéique des rails étant mesurée durant ce fonctionnement, le seul facteur influençant la tension rail-sol mesurée par les capteurs est l'isolation entre les rails et le sol. La mesure de cette tension et l'étude de l'évolution de ces mesures au cours du temps permettent donc d'analyser l'évolution de l'isolation entre les rails et le sol. Ainsi, dans la méthode de surveillance de l'invention, les courants vagabonds générés par la circulation des véhicules ferroviaires ne sont pas directement mesurés, mais la connaissance de l'isolation entre les rails et le sol permet d'en déduire l'évolution des courants vagabonds, qui sont directement causés par le défaut d'isolation rail-sol. En d'autres termes, l'utilisation d'une source de courant stabilisée pour générer un courant connu et maîtrisé permet de surveiller les courants vagabonds en s'affranchissant du besoin de les mesurer directement.

Avantageusement, le système de surveillance 7 comporte en outre des capteurs annexes 9 de tension des rails. Chaque section S et S' des rails 2 comprend deux capteurs annexes 9, qui sont disposés aux deux extrémités de la section. En pratique, les capteurs annexes sont donc situés à proximité immédiate des capteurs de tension rail-sol 73, et chaque capteur de tension 73 est situé entre deux capteurs annexes 9. Par exemple, la distance entre les capteurs 73 et les capteurs annexe 9 est de 1m.

Ces capteurs annexes 9 de tension des rails mesurent la tension des rails 2, notée $T_{rail}$, lorsqu'un courant stabilisé est émis par la source de courant 71. Pour cela, chaque capteur annexe comprend deux points de mesure placés sur les rails 2 et séparés d'une distance D comprise entre 10cm et 1m, de préférence égale à 50cm.

Pour la clarté du dessin, seuls quatre capteurs annexes 9 sont représentés à la figure 1, même si leur nombre au sein de l'infrastructure 1 est bien supérieur.

Grâce aux capteurs annexes 9 de tension des rails, le courant circulant sur les rails 2 au niveau de chaque capteur annexe, noté $C_{rail}$, est calculé par l'unité de calcul déportée 79, selon la formule suivante :

$$C_{rail} = \frac{T_{rail}}{R_{rail \times D}}$$

La méthode de surveillance des courants vagabonds de l'invention comprend deux phases : une phase de déploiement P1 et une phase d'exploitation P2.

La phase de déploiement P1 comprend les étapes suivantes :

- P110 : installation de l'infrastructure ferroviaire 1.
- P130 : mesure initiale de la tension rail-sol. Cette mesure permet d'établir une valeur de référence de tension T1 correspondant à l'état neuf de l'infrastructure ferroviaire. En pratique, une valeur de référence T1 est établie pour chaque capteur 73. Ces mesures sont prises en plusieurs points, c'est-à-dire au niveau de plusieurs capteurs 73, de préférence chaque capteur 73. En outre, une valeur de référence de courant C1 et C'1 circulant dans chaque section S et S' des rails 2 est calculée, à partir des tensions de référence T1 mesurées par les capteurs 73 situés aux deux extrémités de la section et de la résistance électrique linéique des rails, d'après les formules :

$$C1 = \frac{\Delta T1}{R_{rail \times L}}$$

pour les sections S

$$C'1 = \frac{\Delta T1}{R_{rail \times L'}}$$

pour la section S' où $\Delta T1$ est la différence entre les tensions T1 mesurées aux deux extrémités de la section considérée.

- P190 : fin de la phase P1

La phase d'exploitation P2 est exécutée régulièrement au cours de l'exploitation de l'infrastructure ferroviaire, par exemple une fois par nuit ou selon une autre fréquence déterminée par l'exploitant, et comprend les étapes suivantes :

- P210 : émission par la source de courant 71 d'un courant stabilisé se propageant dans les rails 2. Ce courant dépend de l'isolation entre les rails 2 et le sol 3, ainsi que de la longueur des rails 2 et varie, par exemple, de 50 à 350 ampères
- P230 : mesure en plusieurs points de la tension T2 rail-sol par les capteurs de tension 73.
- P250 : transmission des données mesurées depuis les capteurs de tension 73 vers l'unité de calcul déportée 79, par l'intermédiaire de l'unité locale de calcul 77.
- P260 : calcul, par l'unité de calcul déportée 79, des courants C2 et C'2 circulant dans chaque section S et S' des rails 2, d'après les formules :

$$C2 = \frac{\Delta T2}{R_{rail \times L}}$$

pour les sections S

$$C'2 = \frac{\Delta T2}{R_{rail} \times L'}$$

pour la section S'
où $\Delta T2$ est la différence entre les tensions T2 mesurées par les capteurs 73 aux deux extrémités de la section considérée. Les courants C2 et C'2 calculés sont des approximations des courants circulant réellement dans les sections S et S'. Équiper l'infrastructure ferroviaire de plusieurs capteurs 73 permet d'une part de fiabiliser les mesures de tension rail-sol dans le cas de rails de grande longueur, et d'autre part de localiser l'emplacement sur les rails 2 d'une éventuelle dégradation de l'isolation. En chaque point, la tension rail-sol mesurée T2 est représentative de l'isolation rail-sol. En effet, pour un courant donné émis par la source 71 lors de l'étape P210, par exemple 100 ampères, et pour une section S donné, une partie du courant circule dans les rails 2, par exemple 70 ampères, et une partie fuit dans le sol 3, par exemple 30 ampères, cette répartition étant dépendante de l'isolation rail-sol de la section S. Dans le cas théorique d'une isolation rail-sol parfaite, 100% du courant circulerait dans les rails 2 et aucun courant ne fuirait vers le sol 3, la tension rail-sol T2 serait alors maximale.

Lorsqu'une dégradation de l'isolation rail-sol est présente sur une section, les tensions rail-sol T2 mesurées sur l'ensemble des sections diminuent et les courant C2 et C'2 calculés sur l'ensemble des sections varient, cette variation étant plus forte sur la section dont l'isolation est dégradée. Plus l'isolation rail-sol est dégradée, plus la diminution des tensions T2 est importante et plus la variation des courants C2 et C'2 est importante.

- P270 : analyse, par l'unité de calcul déportée 79, des données mesurées par les capteurs de tension à l'étape P230 et des données calculées à l'étape P260. Cette analyse consiste, d'une part, à comparer, pour les données issues de chaque capteur 73, les tensions mesurées T2 lors de l'étape P230 aux tensions de référence T1 mesurées lors de l'étape P130, et éventuellement aux tensions mesurées T2 lors de l'étape P230 des phases P2 précédemment exécutées et, d'autre part, à comparer les courants C2 et C'2 calculés lors de l'étape P260 aux courants de référence C1 et C'1 calculés lors de l'étape P130, et éventuellement aux courants C2 et C'2 calculés lors de l'étape P260 des phases P2 précédemment exécutées. Si en chaque point de mesure, c'est-à-dire pour les données issues de chaque capteur de tension, d'une part, la tension mesurée T2 est conforme à la tension de référence T1 et éventuellement aux tensions T2 mesurées lors de phases précédentes et, d'autre part, le courant C2 ou C'2 calculé est conforme au courant C1 ou C'1 de référence et éventuellement aux courants C2 ou C'2 mesurés lors de phases précédentes, alors la phase P2 se termine dans une étape P290. Si un écart trop important est mesuré, c'est-à-dire si, en un ou plusieurs points de mesure correspondant à un capteur 73, la tension mesurée et le courant calculé évoluent de manière significative au cours du temps, c'est-à-dire par exemple si la tension ou le courant s'écarte de plus de 15% de la valeur de référence, l'unité de calcul déportée détecte une dégradation significative de l'isolation rail-sol. L'étape P280 est alors déclenchée. En fonction des points de mesure présentant une évolution importante du courant circulant dans les rails et de leur localisation, la dégradation de l'isolation rail-sol peut être localisée le long des rails 2. Le critère de choix pour déterminer si un écart des tensions rail-sol mesurées par rapport aux tensions de référence ou si un écart des courants calculés circulant dans les rails par rapport aux courants de référence sont trop importants et constituent un défaut est par exemple :

  ◦ la valeur absolue d'un écart entre le courant calculé en un point de mesure et la valeur de référence du courant en ce point de mesure est égale à au moins 5% de la valeur de référence. Dans ce cas, par « conforme », on entend que la différence C2-C1 ou C'2-C'1 est, en valeur absolue, inférieure à moins de 5% de la valeur C1 ou C'1 ;
  ◦ la valeur absolue d'un écart entre la tension en un point de mesure et la valeur de tension T2 mesurée lors de la phase précédente est égale à au moins 5% de la valeur de tenions T2 mesurée lors de la phase précédente ;
  ◦ un changement du profil de la courbe d'évolution des tensions mesurées au cours du temps ; ou encore
  ◦ un changement du profil de la courbe d'évolution des courants calculés au cours du temps.
  ◦ D'autres critères de choix peuvent être appliqués.

- P280 : alerte de l'exploitant de l'infrastructure ferroviaire 1. L'unité de calcul déportée 79 est configurée pour alerter l'exploitant de l'infrastructure ferroviaire 1 de la dégradation de l'isolation rail-sol lorsqu'un défaut est détecté. Cette alerte peut par exemple être l'envoi automatique d'un e-mail, l'affichage d'un message d'alerte dans un poste de contrôle de l'infrastructure 1, ou l'envoi d'instructions prédéterminées.

La localisation approximative de la dégradation de l'isolation rail-sol le long des rails 2 est permise par l'utilisation de plusieurs capteurs 73. En effet, lorsqu'un défaut d'isolation apparaît, le courant circulant dans les rails ne varie pas de manière uniforme le long des rails 2, et cette variation de courant sera plus importante à proximité du défaut, c'est-à-dire sur la section S ou S' qui contient le défaut. Ainsi, la variation des courants C2 et C'2 calculés est plus importante pour le courant C2 ou C'2 de la section contenant ce défaut que pour les courants mesurés sur les autres sections, ce qui permet d'identifier la section contenant l'emplacement sur les rails 2 où la dégradation de l'isolation est située. En pratique, la section où la dégradation est située est donc la section où le courant C2 ou C'2 calculé varie le plus fortement.

Tant qu'aucune dérive n'est détectée à l'étape 270, la phase d'exploitation P2 est répétée au cours du temps, à une fréquence donnée, afin d'effectuer un suivi permanent de l'isolation rail-sol. Par exemple, la phase P2 est effectuée quotidiennement, ou encore de façon hebdomadaire.

Une autre façon de localiser la dégradation de l'isolation rails-sol au cours de l'étape d'analyse P270 est d'utiliser un modèle incluant des résistances disposées en échelle, où des résistances longitudinales, notées « RL », représentent le rail et sa résistance électrique longitudinale, de sorte que chaque résistance longitudinale corresponde à la résistance du rail sur une section S ou S', et dans lequel des résistances transversales, notées «RT», placées aux endroits des capteurs de tension 73, représentent l'isolement entre le rail et le sol. À partir des dernières mesures de tension, du courant injecté par la source de courant 71, et de la dernière mesure de la résistance de rail, un ensemble de valeurs de référence est calculé pour l'ensemble de résistances transversales RT.

Ainsi, à chaque nouvelle mesure conjointe de la résistance de rail, du courant injecté, et des tensions rail-sol, il est possible de recalculer les éléments du modèle de résistances disposées en échelle, c'est-à-dire les résistances longitudinales RL et transversales RT. Sur la base de valeurs de références calculées au cours de la phase de déploiement P1 de la méthode de surveillance, la comparaison des valeurs de résistances transversales calculées avec les valeurs de résistances transversales RT de référence permet, en cas d'apparition d'un défaut, de localiser la ou les sections S et S' dans lesquelles une variation de l'isolement de la voie se produit.

Plus précisément, en connaissant la résistance longitudinale RL des rails, le courant injecté et les tensions rail-sol, seules les résistances transversales RT sont inconnues. Ces résistances transversales sont alors déterminées par un calcul matriciel.

Ainsi, lors de l'installation du système de surveillance, autrement dit lors de la phase de déploiement P1 de la méthode de surveillance, un modèle de résistances électriques propre à la voie, et dépendant particulièrement des résistances transversales RT, est obtenu. Puis, lors d'une mesure d'isolation de la voie, si la valeur des résistances longitudinales RL des sections S ou S' sont sensiblement identiques aux valeurs de référence, mesurées lors de l'installation du système de surveillance), on mesure de nouvelles tensions rail-sol à l'aide des capteurs 73, qui sont sensiblement égales aux tensions rail-sol de références si aucun défaut n'est présent sur les sections concernées. Dans le cas où les valeurs des nouvelles tension rail-sol diffèrent des valeurs de tensions rail-sol de référence, généralement en étant inférieures à ces valeurs de référence, les nouvelles résistances transversales RT sont déterminées, à l'aide d'un calcul matriciel. Le rapport des nouvelles valeurs de résistances transversales RT sur les valeurs de résistances transversales RT de références permet alors d'apprécier l'évolution de l'isolation de la voie. Notamment, plus ce rapport est éloigné de 1, plus le défaut d'isolation de la voie est important.

Par ailleurs, dans le cas où les résistances longitudinales ont variées, par exemple du fait d'une variation de la température ambiante, un nouveau modèle de référence doit être déterminé. En se basant sur les valeurs des résistances transversales de référence, et en tenant compte des nouvelles valeurs de résistantes longitudinales RL, les tensions rail-sol théoriquement attendues au niveau des capteurs de tension 73 sont déterminées. La mesure des tensions rail-sol, à l'aide des capteurs 73, permet ensuite de déterminer les résistances transversales RT, comme expliqué ci-dessus. La présence d'un défaut dans l'isolation de la voie et l'évolution d'un tel défaut sont ensuite observées en étudiant le rapport des valeurs des résistances RT déterminées sur les résistances transversales de référence.

La phase P2 est effectuée en l'absence de toute circulation de véhicule ferroviaire sur l'infrastructure ferroviaire 1, afin de s'affranchir de toute autre source de courant, par exemple des courants d'alimentation nécessaires à la mise en mouvement des véhicules. Cela a pour avantage de s'assurer que la méthode de surveillance n'analyse que la variation de l'isolation de la voie. Par exemple, la phase P2 est réalisée la nuit.

Un autre mode de réalisation de la méthode de surveillance des courants vagabonds consiste à calculer, pour chaque section S ou S', la valeur de l'isolation G entre les rails 2 et le sol 3 sur cette section en approximant la valeur du courant $I_2$ circulant dans les rails et sortant de cette section. Ce calcul est effectué lors d'une étape supplémentaire P265, se déroulant entre les étapes P260 et P270. Il est effectué dans un premier temps pour la section S', puis successivement pour chaque section S des rails 2, en débutant par la section S adjacente à la section S'.

La formule appliquée est la suivante :

$$\begin{pmatrix} V_2 \\ I_2 \end{pmatrix} = \begin{pmatrix} \cosh(\sqrt{GR_{rail}} \times l) & -\sqrt{R_{rail}/G} \times \sinh(\sqrt{GR_{rail}} \times l) \\ -\sqrt{G/R_{rail}} \times \sinh(\sqrt{GR_{rail}} \times l) & \cosh(\sqrt{GR_{rail}} \times l) \end{pmatrix} \cdot \begin{pmatrix} V_1 \\ I_1 \end{pmatrix}$$

Dans laquelle :

- $V_1$ et $V_2$ sont les tensions, exprimées en volts, entre les rails 2 et le sol 3 respectivement en entrée et en sortie de la section S ou de la section S', mesurées à l'aide des capteurs de tension rail-sol 73 situé aux extrémités de la section, qui correspondent donc en pratique aux tensions rail-sol T2. Dans le cas de la première section S', la tension rail-sol V1 est mesurée au niveau de la source de courant 71.
- $I_1$ et $I_2$ sont les courants, exprimés en ampères, circulants sur les rails 2 respectivement en entrée et en sortie de la section S ou de la section S'. Dans le cas de la première section S', $I_1$ correspond au courant stabilisé émis par la source de courant 71, qui est donc connu.
- $R_{rail}$ est la résistance électrique linéique des rails 2, en Ohm/km.
- $\ell$ est la longueur de la section sur laquelle la formule est appliquée exprimée en kilomètres, c'est-à-dire la longueur L pour les sections S et la longueur L' pour la section S'
- G est l'isolation rail-sol de la section, calculée en S/km.
- cosh et sinh représentent respectivement la fonction cosinus hyperbolique et la fonction sinus hyperbolique.

Cette formule comporte deux inconnues, qui sont le courant $I_2$ en sortie de la section sur laquelle la formule est appliquée et l'isolation rail-sol G de la section, et deux équations, ce qui permet sa résolution. Le courant $I_2$ calculé en sortie d'une section correspondant au courant $I_1$ en entrée de la section adjacente, il est ainsi possible de calculer, pour chaque section successivement, le courant circulant dans les rails en sortie de la section et l'isolation rail-sol de la section, en commençant par la section S'.

Les données calculées par cette formule permettent ensuite de compléter l'analyse réalisée au cours de l'étape P270, car elles fournissent une estimation des valeurs d'isolation rail-sol de chaque section des rails 2. Ces données supplémentaires permettent d'augmenter la fiabilité de la méthode de surveillance de l'évolution des courants vagabonds et de fournir plus d'informations à l'exploitant de l'infrastructure ferroviaire 1.

Un autre mode de réalisation de la méthode de surveillance des courants vagabonds consiste à calculer précisément, pour chaque section S ou S', la valeur de l'isolation G' entre les rails 2 et le sol 3. Ce calcul est effectué lors l'une étape supplémentaire P265' se déroulant entre les étapes P260 et P270 à l'aide des capteurs de tension annexes 9, qui permettent, pour les extrémités de chaque section S ou S', de mesurer la tension $T_{rail}$ et de calculer précisément le courant $C_{rail}$. La formule permettant de calculer la valeur de l'isolation G' pour une section est la suivante :

$$G' = \frac{1}{l} \times \frac{I_1' - I_2'}{(U_1 + U_2)/2}$$

Dans laquelle :

- G' est l'isolation rail-sol de la section, exprimée en S/km.
- $\ell$ est la longueur de la section sur laquelle la formule est appliquée exprimée en kilomètres, c'est-à-dire la longueur L pour les sections S et la longueur L' pour la section S' .
- $U_1$ et $U_2$ sont les tensions, exprimées en volts, mesurées par les capteurs annexes 9 de tension des rails aux deux extrémités de la section S ou de la section S'. Ces tensions correspondent donc en pratique aux tensions $T_{rail}$.
- $I_1'$ et $I_2'$ sont les courants, exprimés en ampères, circulants sur les rails 2 aux deux extrémités de la section S ou de la section S'. Ces courants correspondent donc en pratique aux courants $C_{rail}$.

Ainsi, grâce à l'ajout des capteurs annexes 9 de tension des rails sur l'infrastructure ferroviaire 1, l'isolation G' entre les rails 2 et le sol 3 peut être calculée de manière précise pour chaque section S et S' et son évolution contrôlée au cours du temps. En effet, les données utilisées pour le calcul étant mesurées lorsqu'un courant stabilisé et maîtrisé est émis par la source de courant 71, les différentes variables pouvant influencer le calcul de l'isolation G' sont maîtrisées par l'exploitant de l'infrastructure ferroviaire. Grâce à ce calcul, la méthode de surveillance est améliorée :

- au cours de l'étape P130 de la phase P1, pour chaque section, une valeur de référence de l'isolation rail-sol $G'_1$ est calculée ;

- au cours de l'étape P230 de la phase P2, pour chaque capteur annexe 9, une valeur de tension des rails 2 $T_{rail}$ est mesurée ;
- au cours de l'étape P265' de la phase P2, pour chaque section, une valeur des courants $C_{rail}$ et de l'isolation rail-sol $G'_2$ est calculé ; et
- au cours de l'étape P270, l'unité de calcul analyse, pour chaque section S et S', l'évolution de l'isolation $G'_2$ au cours du temps. Cette analyse consiste à comparer, pour chaque section, l'isolation $G'_2$ calculée lors de l'étape P230 à l'isolation de référence $G'_1$ calculée lors de l'étape P130 et éventuellement aux isolations $G'_2$ calculées lors de l'étape P230 des phases P2 précédemment exécutées. Lorsqu'une dérive trop importante de l'isolation rail-sol est détectée sur une ou plusieurs sections S ou S', l'étape P280 est déclenchée. Par exemple, une dérive trop importante sera détecté si la valeur absolue d'un écart entre $G'_2$ et $G'_1$ est égale au moins 5% de $G'_1$, ou si le profil de la courbe d'évolution des isolations rail-sol calculées au cours du temps change.

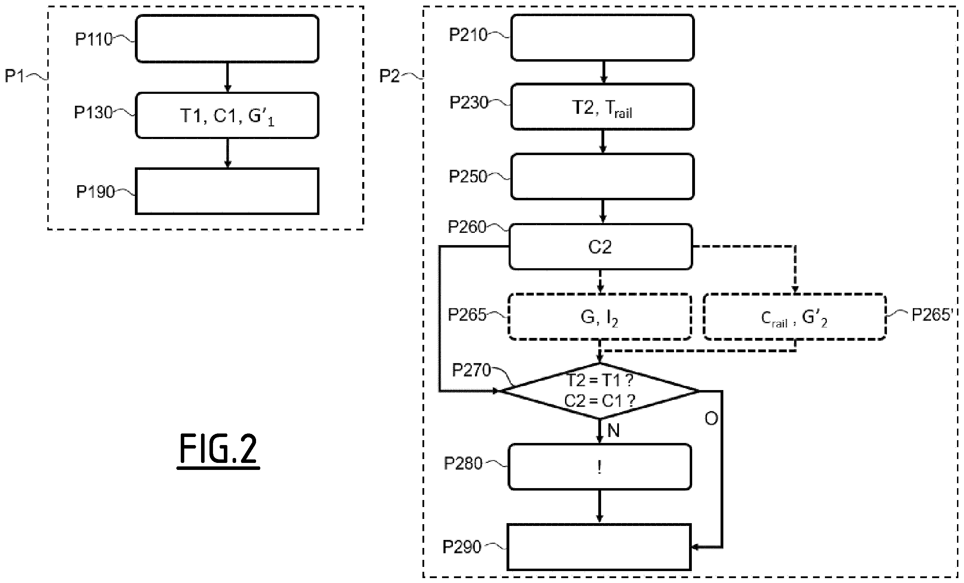

Les étapes P265 et P'265 étant optionnelles, puisque non mises en oeuvre dans le premier mode de réalisation de l'invention, elles sont représentées en pointillés à la figure 2.

En variante non-représentée de l'invention, la phase P2 comprend une étape supplémentaire P205, préalable à l'étape P210, qui consiste à vérifier l'absence de circulation de véhicules ferroviaires sur l'infrastructure 1, par exemple en effectuant une mesure de tension rail-sol, censée être négligeable en l'absence de circulation.

En variante non-représentée de l'invention, le courant stabilisé généré à l'étape P210 provient de plusieurs sources 71 qui émettent successivement un courant identique. Par exemple, une source de courant stabilisée 71 est installée tous les 25 à 35 km le long des rails 2. L'utilisation de plusieurs sources 71 permet de fiabiliser la méthode de surveillance sur des infrastructures de grande longueur.

En variante non-représentée de l'invention, la phase P1 ne comprend pas l'étape de mesures initiales P130 et la méthode de surveillance se base uniquement sur l'analyse de la variation des mesures de tension T2, effectuées à l'étape P230 de la phase P2, et de la variation des courants C2 et C'2 calculés à l'étape P260 de la phase P2, au cours du temps.

En variante non-représentée de l'invention, à l'étape P230, une partie seulement des capteurs 73 effectuent une mesure de la tension rail-sol T2.

En variante non-représentée de l'invention, le système de surveillance 7 contient un unique capteur de tension rail-sol 73.

En variante non-représentée de l'invention, les étapes P260 et P270 sont exécutées par l'unité locale de calcul 77.

Les modes de réalisation et les variantes envisagés ci-dessus peuvent être combinés pour générer de nouveaux modes de réalisation dans l'invention.

**Revendications**

1.  Méthode de surveillance de l'évolution des courants vagabonds d'une infrastructure ferroviaire (1), l'infrastructure ferroviaire comprenant :

    - des rails (2) posés sur un sol (3) et isolés du sol par un système d'isolation (21), les rails définissant au moins une section (S, S') de voie ;
    - des sous-stations (5) générant une tension, de préférence continue, d'alimentation d'un véhicule ferroviaire ; et
    - un système de surveillance (7) comprenant au moins un capteur de tension rail-sol (73) et au moins une unité de calcul (77, 79) ;
    **caractérisé en ce que** l'infrastructure ferroviaire comprend en outre au moins une source de courant stabilisée (71),
    **en ce que** la méthode de surveillance comprend une phase d'exploitation (P2) comprenant au moins les étapes suivantes :

    - (P210) émission d'un courant stabilisé par chaque source de courant (71) dans au moins un des rails ;
    - (P230) mesure de la tension (T2) générée par le courant stabilisé entre les rails (2) et le sol (3) par l'au moins un capteur de tension rail-sol (73) ;
    - (P260) calcul, par l'unité de calcul (77, 79), du courant (C2, C'2) circulant dans chaque section (S, S') issu de la source de courant ; et
    - (P270) analyse par l'unité de calcul (77, 79) de la tension mesurée par le capteur de tension rail-sol (79) et du courant calculé et détection d'une possible dégradation de l'isolation entre les rails (2) et le sol (3),

et **en ce que**, au cours de la phase d'analyse (P270), l'unité de calcul (77, 79) analyse la tension mesurée par le capteur de tension rail-sol (79) et le courant calculé et détecte une possible dégradation de l'isolation entre les rails (2) et le sol (3) par comparaison d'une part de la tension mesurée à une valeur précédente de tension rail-sol (T1, T2) et d'autre part du courant calculé à une valeur précédente du courant (C1, C'1, C2, C'2) circulant dans les rails.

2. Méthode de surveillance selon la revendication 1, **caractérisée en ce qu'**elle comporte une phase de déploiement (P1) comprenant au moins une étape initiale (P130) consistant, d'une part, à mesurer pour chaque capteur de tension rail-sol (73) une valeur de référence (T1) de la tension générée par le courant stabilisé entre les rails (2) et le sol (3) et, d'autre part, à calculer pour chaque section (S, S') une valeur de référence (C1, C'1) du courant circulant dans les rails issu de la source de courant.

3. Méthode de surveillance selon la revendication 2, **caractérisée en ce que** au cours de l'étape d'analyse (P270) par l'unité de calcul (77, 79) :

   - pour chaque capteur de tension rail-sol (73), la comparaison est effectuée entre la tension rail-sol (T2) mesurée lors de l'étape de mesure (P230) et la valeur de référence (T1) de la tension rail-sol mesurée lors de l'étape de mesure initiale (P130) ; et
   - pour chaque section (S, S'), la comparaison est effectuée entre le courant (C2, C'2) circulant sur la section calculé lors de l'étape de calcul (P260) et la valeur de référence (C1, C'1) du courant circulant dans les rails calculée lors de l'étape de calcul initial (P130).

4. Méthode de surveillance selon l'une quelconque des revendications précédentes, **caractérisée en ce que** le système de surveillance (7) de l'infrastructure ferroviaire (1) comprend au moins deux capteurs de tension rail-sol (73) et au moins deux sections (S, S') et **en ce que** l'étape d'analyse (P270) de la phase d'exploitation (P2) localise l'emplacement sur les rails (2) de la dégradation de l'isolation entre les rails (2) et le sol (3) en identifiant la section (S, S') sur laquelle la variation du courant (C2, C'2) est la plus forte, la dégradation de l'isolation étant réputée être située sur cette section.

5. Méthode de surveillance selon l'une quelconque des revendications précédentes, **caractérisée en ce que** le système de surveillance (7) de l'infrastructure ferroviaire (1) comprend au moins deux capteurs de tension rail-sol (73) et au moins deux sections (S, S') et **en ce que** l'étape d'analyse (P270) de la phase d'exploitation (P2) localise l'emplacement sur les rails (2) de la dégradation de l'isolation entre les rails (2) et le sol (3) sur la base d'un modèle comprenant des résistances longitudinales (RL) représentant chacune la résistance électrique longitudinale du rail (2) sur une sections (S, S') et des résistances transversales (RT) représentant l'isolement rail-sol au niveau des capteurs de tension rail-sol (73), dans lequel les résistances transversales sont calculées à partir de la tension (T2) entre les rails (2) et le sol (3) mesurée par les capteurs de tension (73), du courant émis par les sources de courant (71) et des résistances longitudinales (RL), de préférence à l'aide d'un calcul matriciel, et dans lequel les valeurs des résistances transversales sont comparées avec des valeurs de référence, calculées au cours d'une phase de déploiement (P1) de la méthode de surveillance, pour localiser l'emplacement de la dégradation de l'isolation.

6. Méthode de surveillance selon l'une quelconque des revendications précédentes, **caractérisée en ce que** la phase d'exploitation (P2) est exécutée en l'absence de circulation de véhicules ferroviaires sur l'infrastructure ferroviaire (1) et **en ce que** la phase d'exploitation (P2) comporte une étape supplémentaire (P205), préalable à l'étape (P210) d'émission d'un courant stabilisé, qui consiste à vérifier l'absence de circulation de véhicules ferroviaires sur l'infrastructure (1).

7. Méthode de surveillance selon l'une quelconque des revendications précédentes, **caractérisée en ce que** la phase d'exploitation (P2) comporte une étape (P265) supplémentaire consistant à calculer, pour chaque section (S, S'), une valeur de l'isolation (G) entre les rails (2) et le sol (3) en approximant le courant ($I_2$) circulant dans les rails (2) et **en ce que** l'étape d'analyse (P270) de la phase d'exploitation (P2) analyse également cette valeur d'isolation pour détecter une possible dégradation de l'isolation entre les rails (2) et le sol (3).

8. Méthode de surveillance selon l'une quelconque des revendications 1 à 6, **caractérisée en ce que** :

   - l'infrastructure ferroviaire (1) comporte en outre des capteurs annexes (9) de tension des rails (2) disposés à chaque extrémité de chaque section (S, S');
   - au cours de l'étape de mesure (P230) de la phase d'exploitation (P2), les capteurs annexes mesurent la

tension des rails ($T_{rail}$) à chaque extrémité de chaque section (S, S') lorsqu'un courant stabilisé est émis par la source de courant (71) ;

- la phase d'exploitation (P2) comporte une étape de calcul (P265') supplémentaire dans laquelle l'unité de calcul (77, 79) calcule, à partir de ces tensions des rails, le courant ($C_{rail}$) circulant sur les rails à chaque extrémité de chaque section des rails ;

- au cours de l'étape de calcul de la phase d'exploitation, à partir de ces courants, l'unité de calcul (77, 79) calcule une valeur de l'isolation ($G'_2$) entre les rails (2) et le sol (3) pour chaque section (S, S') ; et

- au cours de l'étape d'analyse (P270) de la phase d'exploitation, l'unité de calcul (77, 79) analyse, pour chaque section (S, S') des rails (2), l'évolution de l'isolation ($G'_1$, $G'_2$) entre les rails et le sol pour détecter une possible dégradation de cette isolation.

9. Infrastructure ferroviaire (1) comprenant :

- des rails (2) posés sur un sol (3) et isolés du sol par un système d'isolation (21) ;
- des sous-station (5) générant une tension, de préférence continue, d'alimentation d'un véhicule ferroviaire ; et
- un système de surveillance (7) comprenant des capteurs de tension rail-sol (73) et au moins une unité de calcul (77, 79) ;

**caractérisée en ce que** le système de surveillance (7) de l'infrastructure ferroviaire (1) comprend en outre :

- au moins une source de courant stabilisée (71) ;
- éventuellement des capteurs annexe (9) de tension des rails ; et
- des moyens (71-79) de mise en oeuvre de la méthode de surveillance des revendications 1 à 8.

**Patentansprüche**

1. Überwachungsverfahren der Entwicklung vagabundierender Ströme einer Eisenbahninfrastruktur (1), die Eisenbahninfrastruktur umfassend:

- Schienen (2), die auf einem Boden (3) verlegt und durch ein Isolationssystem (21) von dem Boden isoliert sind, wobei die Schienen mindestens einen Abschnitt (S, S') des Gleises definieren;
- Unterstationen (5), die eine Spannung, vorzugsweise Gleichspannung, zum Versorgen eines Schienenfahrzeugs erzeugen; und
- ein Überwachungssystem (7), umfassend mindestens einen Schiene-Boden-Spannungssensor (73) und mindestens eine Recheneinheit (77, 79);
**dadurch gekennzeichnet, dass** die Eisenbahninfrastruktur ferner mindestens eine stabilisierte Stromquelle (71) umfasst,
dass das Überwachungsverfahren eine Betriebsphase (P2) umfasst, umfassend mindestens die folgenden Schritte:

- (P210) Emittieren eines stabilisierten Stroms durch jede Stromquelle (71) in mindestens eine der Schienen;
- (P230) Messen, durch den mindestens einen Schiene-Boden-Spannungssensor (73), der Spannung (T2), die durch den stabilisierten Strom zwischen den Schienen (2) und dem Boden (3) erzeugt wird;
- (P260) Berechnen, durch die Recheneinheit (77, 79), des Stroms (C2, C'2), der in jedem Abschnitt (S, S') fließt, der von der Stromquelle herrührt; und
- (P270) Analysieren der von dem Schiene-Boden-Spannungssensor (79) gemessenen Spannung und des berechneten Stroms durch die Recheneinheit (77, 79) und Erkennen einer möglichen Verschlechterung der Isolierung zwischen den Schienen (2) und dem Boden (3),

und dass im Verlauf der Analysephase (P270) die Recheneinheit (77, 79) die von dem Schiene-Boden-Spannungssensor (79) gemessene Spannung und den berechneten Strom analysiert und eine mögliche Verschlechterung der Isolierung zwischen den Schienen (2) und dem Boden (3) durch Vergleich einerseits der gemessenen Spannung mit einem vorherigen Wert der Schiene-Boden-Spannung (T1, T2) und andererseits des berechneten Stroms mit einem vorherigen Wert des in den Schienen fließenden Stroms (C1, C'1, C2, C'2) erkennt.

2. Überwachungsverfahren nach Anspruch 1, **dadurch gekennzeichnet, dass** es eine Einsatzphase (P1) umfasst, umfassend mindestens einen Anfangsschritt (P130), der einerseits darin besteht, für jeden Schiene-Boden-Spannungssensor (73) einen Referenzwert (T1) der Spannung zu berechnen, die durch den stabilisierten Strom zwischen den Schienen (2) und dem Boden (3) erzeugt wird, und andererseits für jeden Abschnitt (S, S') einen Referenzwert (C1, C'1) des in den Schienen fließenden Stroms zu berechnen, der von der Stromquelle herrührt.

3. Überwachungsverfahren nach Anspruch 2, **dadurch gekennzeichnet, dass** im Verlauf des Analyseschritts (P270) durch die Recheneinheit (77, 79):

- der Vergleich für jeden Schiene-Boden-Spannungssensor (73) zwischen der Schiene-Boden-Spannung (T2), die in dem Messschritt (P230) gemessen wird, und dem Referenzwert (T1) der Schiene-Boden-Spannung, die in dem anfänglichen Messschritt (P130) gemessen wird, durchgeführt wird; und
- der Vergleich für jeden Abschnitt (S, S') zwischen dem Strom (C2, C'2), der auf dem Abschnitt fließt, der in dem Berechnungsschritt (P260) berechnet wird, und dem Referenzwert (C1, C'1) des Stroms, der in den Schienen fließt, der in dem anfänglichen Berechnungsschritt (P130) berechnet wird, durchgeführt wird.

4. Überwachungsverfahren nach einem der vorherigen Ansprüche, **dadurch gekennzeichnet, dass** das Überwachungssystem (7) der Eisenbahninfrastruktur (1) mindestens zwei Schiene-Boden-Spannungssensoren (73) und mindestens zwei Abschnitte (S, S') umfasst, und dass der Analyseschritt (P270) der Betriebsphase (P2) die Stelle der Verschlechterung der Isolierung zwischen den Schienen (2) und dem Boden (3) an den Schienen (2) lokalisiert, indem der Abschnitt (S, S') identifiziert wird, in dem das Vagabundieren des Stroms (C2, C'2) am stärksten ist, wobei angenommen wird, dass sich die Verschlechterung der Isolierung in diesem Abschnitt befindet.

5. Überwachungsverfahren nach einem der vorherigen Ansprüche, **dadurch gekennzeichnet, dass** das Überwachungssystem (7) der Eisenbahninfrastruktur (1) mindestens zwei Schiene-Boden-Spannungssensoren (73) und mindestens zwei Abschnitte (S, S') umfasst, und dass der Analyseschritt (P270) der Betriebsphase (P2) die Stelle der Verschlechterung der Isolierung zwischen den Schienen (2) und dem Boden (3) an den Schienen (2) basierend auf einem Modell lokalisiert, umfassend Längswiderstände (RL), die jeweils den elektrischen Längswiderstand der Schiene (2) über einen Abschnitt (S, S') darstellen, und Querwiderstände (RT), die die Schiene-Boden-Isolierung auf Höhe der Schiene-Boden-Spannungssensoren (73) darstellen, wobei die Querwiderstände anhand der Spannung (T2) zwischen den Schienen (2) und dem Boden (3), die von den Spannungssensoren (73) gemessen wird, des Stroms, der von den Stromquellen (71) emittiert wird, und der Längswiderstände (RL), vorzugsweise mittels einer Matrixberechnung berechnet werden, und wobei die Werte der Querwiderstände mit Referenzwerten verglichen werden, die im Verlauf einer Einsatzphase (P1) des Überwachungsverfahrens berechnet werden, um die Stelle der Verschlechterung der Isolierung zu lokalisieren.

6. Überwachungsverfahren nach einem der vorherigen Ansprüche, **dadurch gekennzeichnet, dass** die Betriebsphase (P2) in Abwesenheit von Schienenfahrzeugen auf der Schieneninfrastruktur (1) durchgeführt wird, und dass die Betriebsphase (P2) einen zusätzlichen Schritt (P205) vor dem Schritt (P210) eines Emittierens eines stabilisierten Stroms umfasst, der darin besteht, die Abwesenheit des Verkehrs von Schienenfahrzeugen auf der Infrastruktur (1) zu überprüfen.

7. Überwachungsverfahren nach einem der vorherigen Ansprüche, **dadurch gekennzeichnet, dass** die Betriebsphase (P2) einen zusätzlichen Schritt (P265) umfasst, der darin besteht, für jeden Abschnitt (S, S') einen Wert der Isolierung (G) zwischen den Schienen (2) und dem Boden (3) zu berechnen, indem der in den Schienen (2) fließende Strom ($I_2$) angenähert wird, und dass der Analyseschritt (P270) der Betriebsphase (P2) diesen Isolierungswert auch analysiert, um eine mögliche Verschlechterung der Isolierung zwischen den Schienen (2) und dem Boden (3) zu erkennen.

8. Überwachungsverfahren nach einem der Ansprüche 1 oder 6, **dadurch gekennzeichnet, dass**:

- die Eisenbahninfrastruktur (1) ferner Zusatzsensoren (9) für die Spannung der Schienen (2) umfasst, die an jedem Ende jedes Abschnitts (S, S') angeordnet sind;
- die Zusatzsensoren im Verlauf des Messschritts (P230) der Betriebsphase (P2) die Spannung der Schienen ($T_{schiene}$) an jedem Ende jedes Abschnitts (S, S') messen, wenn ein stabilisierter Strom von der Stromquelle (71) emittiert wird;
- die Betriebsphase (P2) einen ergänzenden Berechnungsschritt (P265') umfasst, bei dem die Recheneinheit (77, 79) anhand dieser Schienenspannungen den Strom ($C_{schiene}$) berechnet, der an jedem Ende von jedem Abschnitt der Schienen an den Schienen fließt;
- anhand dieser Ströme die Recheneinheit (77, 79) im Verlauf des Berechnungsschritts der Betriebsphase einen Wert der Isolierung ($G'_2$) zwischen den Schienen (2) und dem Boden (3) für jeden Abschnitt (S, S') berechnet; und
- die Recheneinheit (77, 79) im Verlauf des Analyseschritts (P270) der Betriebsphase für jeden Abschnitt (S, S') der Schienen (2) die Entwicklung der Isolierung ($G'_1$, $G'_2$) zwischen den Schienen und dem Boden analysiert, um eine mögliche Verschlechterung dieser Isolierung zu erkennen.

9. Eisenbahninfrastruktur (1), umfassend:

- Schienen (2), die auf einem Boden (3) verlegt und durch ein Isolationssystem (21) von dem Boden isoliert sind;
- Unterstationen (5), die eine Spannung, vorzugsweise Gleichspannung, zum Versorgen eines Schienenfahrzeugs erzeugen; und
- ein Überwachungssystem (7), umfassend Schiene-Boden-Spannungssensoren (73) und mindestens eine Recheneinheit (77, 79);

**dadurch gekennzeichnet, dass** das Überwachungssystems (7) der Eisenbahninfrastruktur (1) ferner Folgendes umfasst:

- mindestens eine stabilisierte Stromquelle (71);
- optional Zusatzsensoren (9) für die Schienenspannung; und
- Einrichtungen (71-79) zum Durchführen des Überwachungsverfahrens der Ansprüche 1-8.

## Claims

1. A method for monitoring the evolution of stray currents of a railway infrastructure (1), the railway infrastructure comprising:

   - rails (2) laid on a ground (3) and insulated from the ground by an insulation system (21), the rails defining at least one track section (S, S');
   - substations (5) generating a voltage, preferably DC, to supply a rail vehicle; and
   - a monitoring system (7) comprising at least one ground-rail voltage sensor (73) and at least one calculation unit (77, 79);
   **characterised in that** the railway infrastructure further comprises at least one stabilised current source (71), **in that** the monitoring method comprises an operating phase (P2) comprising at least the following steps:

     - (P210) emission of a stabilised current by each current source (71) in at least one of the rails;
     - (P230) measurement of the voltage (T2) generated by the stabilised current between the rails (2) and the ground (3) by the at least one rail-ground voltage sensor (73);
     - (P260) calculation, by the calculation unit (77, 79), of the current (C2, C'2) flowing in each section (S, S') from the current source; and
     - (P270) analysis by the calculation unit (77, 79) of the voltage measured by the rail-ground voltage sensor (79) and of the calculated current and detection of a possible degradation of the insulation between the rails (2) and the ground (3),

   and **in that**, during the analysis phase (P270), the calculation unit (77, 79) analyses the voltage measured by the ground-rail voltage sensor (79) and the calculated current and detects a possible degradation of the insulation between the rails (2) and the ground (3) by comparing the measured voltage with a previous value of ground-rail voltage (T1, T2) on the one hand, and the calculated current with a previous value of the current (C1, C'1, C2, C'2) flowing in the rails on the other hand.

2. The monitoring method according to claim 1, **characterised in that** it comprises a deployment phase (P1) comprising at least one initial step (P130) consisting, on the one hand, of measuring for each rail-ground voltage sensor (73) a reference value (T1) of the voltage generated by the stabilised current between the rails (2) and the ground (3) and, on the other hand, of calculating for each section (S, S') a reference value (C1, C'1) of the current flowing in the rails from the current source.

3. The monitoring method according to claim 2, **characterised in that** during the step of analysis (P270) by the calculation unit (77, 79):

- for each ground-rail voltage sensor (73), the comparison is made between the ground-rail voltage (T2) measured during the measurement step (P230) and the reference value (T1) of the ground-rail voltage measured during the initial measurement step (P130); and
- for each section (S, S'), the comparison is made between the current (C2, C'2) flowing on the section calculated during the calculation step (P260) and the reference value (C1, C'1) of the current flowing in the rails calculated during the initial calculation step (P130).

4. The monitoring method according to any one of the preceding claims, **characterised in that** the monitoring system (7) of the railway infrastructure (1) comprises at least two rail-ground voltage sensors (73) and at least two sections (S, S') and **in that** the analysis step (P270) of the operating phase (P2) finds the location on the rails (2) of the degradation of the insulation between the rails (2) and the ground (3) by identifying the section (S, S') on which the variation in the current (C2, C'2) is greatest, the degradation of the insulation being deemed to be located in this section.

5. The monitoring method according to any one of the preceding claims, **characterised in that** the monitoring system (7) of the railway infrastructure (1) comprises at least two rail-ground voltage sensors (73) and at least two sections (S, S') and **in that** the analysis step (P270) of the operating phase (P2) finds the location on the rails (2) of the degradation of the insulation between the rails (2) and the ground (3) on the basis of a model comprising longitudinal resistances (RL) each representing the longitudinal electrical resistance of the rail (2) over a section (S, S') and transverse resistances (RT) representing the rail-ground insulation at the rail-ground voltage sensors (73), wherein the transverse resistances are calculated from the voltage (T2) between the rails (2) and the ground (3) measured by the voltage sensors (73), the current emitted by the current sources (71) and the longitudinal resistances (RL), preferably with the aid of a matrix operation, and wherein the values of the transverse resistances are compared with reference values, calculated during a deployment phase (P1) of the monitoring method, to find the location of the insulation degradation.

6. The monitoring method according to any one of the preceding claims, **characterized in that** the operating phase (P2) is carried out in the absence of rail vehicle traffic on the rail infrastructure (1) and **in that** the operating phase (P2) comprises an additional step (P205), prior to the step (P210) of emitting a stabilized current, which consists of verifying the absence of rail vehicle traffic on the infrastructure (1).

7. The monitoring method according to any one of the preceding claims, **characterised in that** the operating phase (P2) comprises an additional step (P265) consisting of calculating, for each section (S, S'), a value of the insulation (G) between the rails (2) and the ground (3) by approximating the current ($I_2$) flowing in the rails (2), and **in that** the analysis step (P270) of the operating phase (P2) also analyses this insulation value in order to detect a possible degradation of the insulation between the rails (2) and the ground (3).

8. The monitoring method according to any of claims 1 to 6, **characterised in that** it comprises:

   - the railway infrastructure (1) further comprises additional sensors (9) of the voltage in the rails (2) arranged at each end of each section (S, S');
   - during the measurement step (P230) of the operating phase (P2), the auxiliary sensors measure the voltage of the rails ($T_{rail}$) at each end of each section (S, S') when a stabilised current is emitted by the current source (71);
   - the operating phase (P2) comprises an additional calculation step (P265') in which the calculation unit (77, 79) calculates, from these rail voltages, the current ($C_{rail}$) flowing on the rails at each end of each rail section;
   - during the calculation step of the operating phase, from these currents, the calculation unit (77, 79) calculates a value for the insulation ($G'_2$) between the rails (2) and the ground (3) for each section (S, S'); and
   - during the analysis step (P270) of the operating phase, the calculation unit (77, 79) analyses, for each section (S, S') of the rails (2), the evolution of the insulation ($G'_1$, $G'_2$) between the rails and the ground in order to detect any deterioration in this insulation.

9. A railway infrastructure (1) comprising:

   - rails (2) laid on a ground (3) and insulated from the ground by an insulation system (21);
   - substations (5) generating a voltage, preferably DC, to supply a rail vehicle; and
   - a monitoring system (7) comprising at least one ground-rail voltage sensor (73) and at least one calculation unit (77, 79);

**characterised in that** the railway infrastructure (1) monitoring system (7) further comprises:

- at least one stabilised current source (71);
- potentially auxiliary rail voltage sensors (9); and
- means (71-79) for implementing the monitoring method of claims 1 to 8.

EP 4 092 435 B1

FIG.1

P1
P110
P130 — T1, C1, G'₁
P190

P2
P210
P230 — T2, T_rail
P250
P260 — C2
P265 — G, I₂
P265' — C_rail , G'₂
P270 — T2 = T1 ? C2 = C1 ?  N / O
P280 — i
P290

$$FIG.2$$

**EP 4 092 435 B1**

## RÉFÉRENCES CITÉES DANS LA DESCRIPTION

### Documents brevets cités dans la description

- US 2004104723 A1
- WO 2017082730 A1